# EUROPEAN PATENT APPLICATION

(11) **EP 1 536 283 A1**
(43) Date of publication of application: **01.06.2005**
(21) Application number: 03738542.4
(22) Date of filing: 27.06.2003
(51) Int. Cl.: G03F 1/16, H01L 21/027

(54) **MASK AND INSPECTION METHOD THEREFOR AND PRODUCTION METHOD FOR SEMICONDUCTOR DEVICE**

(30) Priority: 28.06.2002 JP 2002191099; 07.05.2003 JP 2003129523
(71) Applicant: Sony Corporation, Tokyo 141-0001 (JP)
(72) Inventor: WATANABE, Yoko, c/o SONY CORPORATION, Tokyo 141-0001 (JP); OMORI, Shinji, c/o SONY CORPORATION, Tokyo 141-0001 (JP); IWASE, Kazuya, c/o SONY CORPORATION, Tokyo 141-0001 (JP); AMAI, Keiko, c/o FORUM ENGINEERING INC., Atsugi-shi, Kanagawa 243-0018 (JP); YOSHIZAWA, Masaki, c/o SONY CORPORATION, Tokyo 141-0001 (JP)
(74) Representative: Müller, Frithjof E., Dipl.-Ing.
(86) International application number: PCT/JP2003/008176
(87) International publication number: WO 2004/003664

(57) **Abstract**

To provide a mask that it becomes possible to perform destructive inspection without a mask for inspection or to perform more accurately non-destructive inspection and a method of inspecting the same. A mask comprising a thin film for exposure that has a transmission portion and a non-transmission portion of a beam for exposure, a thick film portion that is formed around the thin film for exposure and that supports the thin film for exposure, and a thin film for inspection that has a transmission portion and a non-transmission portion of the beam for exposure, that is formed at a distance from a thin film for exposure and that has thickness and material equal to those of a thin film for exposure, and a method of inspection of a mask that inspection is performed by using a thin film for inspection, and a method of producing a semiconductor device that lithography is performed by using a thin film for exposure of the mask.

## Description

### TECHNICAL FIELD

The present invention relates to a mask being used at the lithography process in producing of a semiconductor device, a method of inspecting the same, and a method of producing the semiconductor device.

### BACKGROUND ART

As an alternative exposing technology of a next generation to photolithography, a printing type exposing technology using a charge particle such as an electron beam (strut) or an ion beam has being developed. In these new technology mutually, the mask having a thin film region, in other words a membrane, is used. The membrane on the surface of the mask has the thickness of about 100 nm to 10 µm, a printing pattern is placed on the membrane. The membrane is formed by etching a mask material, for example containing a silicon wafer, in part from the reverse side of the mask. A portion without etching of a mask blanks becomes a supporting portion of the membrane.

The thing that the printing pattern is formed by setting an aperture at the membrane in itself is called a stencil mask (refer to H. C. Pfeiffer, Jpn. J. Appl. Phys. 34, 6658 (1995)). Moreover, the thing that the printing pattern is formed by processing a scatterer laminated on the membrane such as a metal film is called a scattering membrane mask.

The printing type lithography contains a thing of a method that a charged particle beam passing through the mask is reduce-projected in an electron/ion optical system, for example SCALPEL of Lucent Technologies, PREVAIL of IBM, and EB stepper or ion beam printing lithography and so on, and a thing of a method that a charged particle beam is printed to a wafer adjacent to the lower mask without an electron/ion optical system, for example LEEPL by TOKYO SEIMITSU CO., LTD and so on. The mask used in LEEPL is disclosed in Japanese Unexamined Patent Publication No.2002-231599, Japanese Unexamined Patent Publication No.2002-252157, Japanese Unexamined Patent Publication No.2002-270496 and Japanese Unexamined Patent Publication No.2002-343710.

In each method, producing the mask having a pattern position with high precision is extremely important. In addition, SCALPEL is an abbreviation of "scattering with angular limitation in projection electron-beam lithography", PREVAIL is an abbreviation of "projection exposure with variable axis immersion lenses", LEEPL is an abbreviation of "low-energy e-beam proximity lithography".

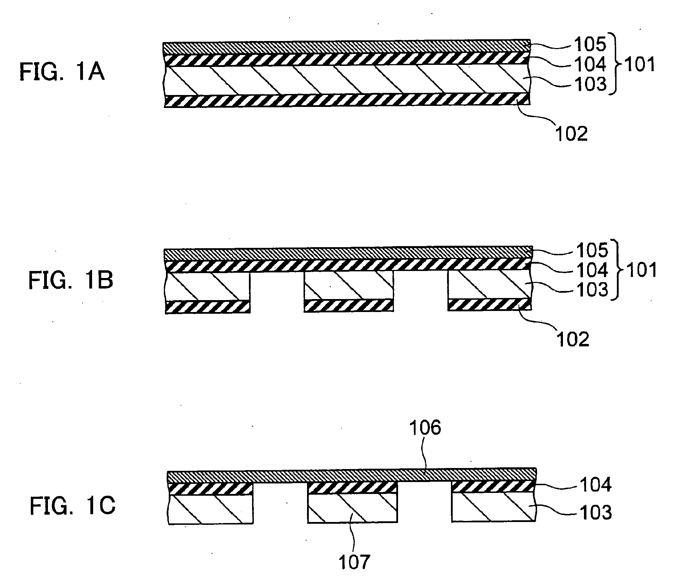

The method of producing these masks may have several variations, a typical manufacturing flow of a stencil mask and a scattering membrane mask will be explained. In the case of the stencil mask, first, as shown in Fig. 1A, a silicon oxide film 102 is formed in the reverse side of a SOI wafer 101. SOI is an abbreviation of "silicon on insulator" or "semiconductor on insulator". The SOI wafer 101 has a silicon layer 105 through a silicon oxide film, in other words an implant oxide film, 104 on a silicon wafer 103. Without showing in a figure, a silicon oxide film 102 is etched.

Next, as shown in Fig. 1B, the silicon wafer 103 is etched from the reverse side of the SOI wafer 101. This etching is performed until reaching a silicon oxide film 104 as the silicon oxide film 102 is a mask. Because the speed of etching silicon and silicon oxide are different in several order or more, the silicon wafer 103 is selectively etched for the silicon oxide film 104 and 102. The etching is stopped at the silicon oxide film 104.

Next, as shown in Fig. 1C, an exposed portion by etching the silicon wafer 103 of the silicon oxide film 104 is removed. Herewith, the membrane 106 consisting of a silicon is formed. The silicon wafer 103 of the portion sectionalizing the membrane 106 is made as a beam 107, and is supporting the membrane 106. The silicon oxide film 104 is removed by for example wet-etching using hydrofluoric acid. Moreover, the silicon oxide film 102 is also removed by this etching. Without showing in a figure, the membrane 106 and the beam 107 are not formed adjacent to an edge of the SOI wafer 101, and the silicon wafer left in this portion is used as a supporting frame of the mask.

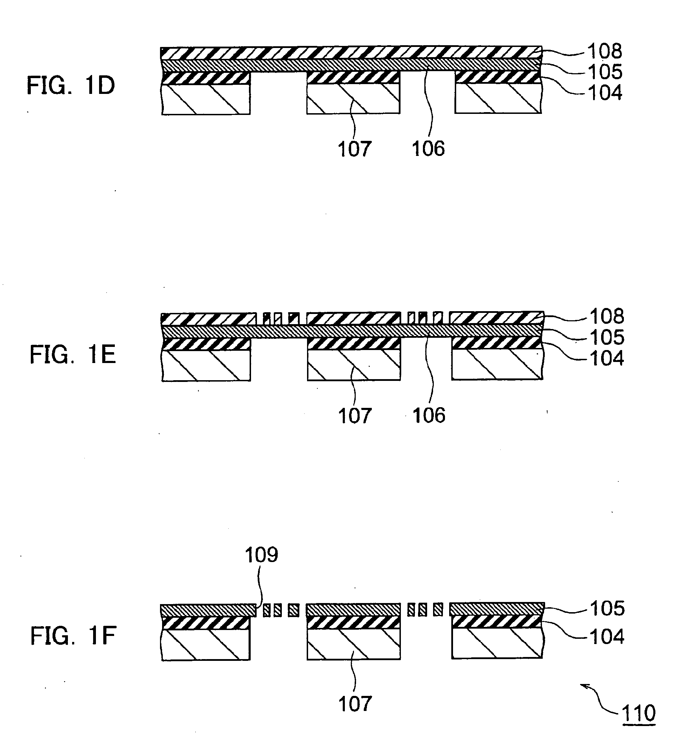

Next, as shown in Fig.1D, an electron beam resist 108 is applied on a silicon layer 105 containing the membrane 106. Next, as shown in Fig.1E, a mask pattern is drawn on the resist 108 and the resist 108 is developed. An electron beam drawing machine is used for the drawing the mask pattern.

Next as shown in Fig.1F, the silicon layer 105 is etched as the resist 108 is a mask, and an aperture 109 is formed by printing pattern. Afterward, by removing the resist 108, a stencil mask 110 is formed. The charged particle beam is irradiated from the reverse side, in other words the beam 107 side, of the stencil mask 110, and the pattern is printed to the wafer by the charged particle beam passing through the aperture 109. In an exposing method of equal scale such as LEEPL, the membrane 106 and the wafer are located contiguously.

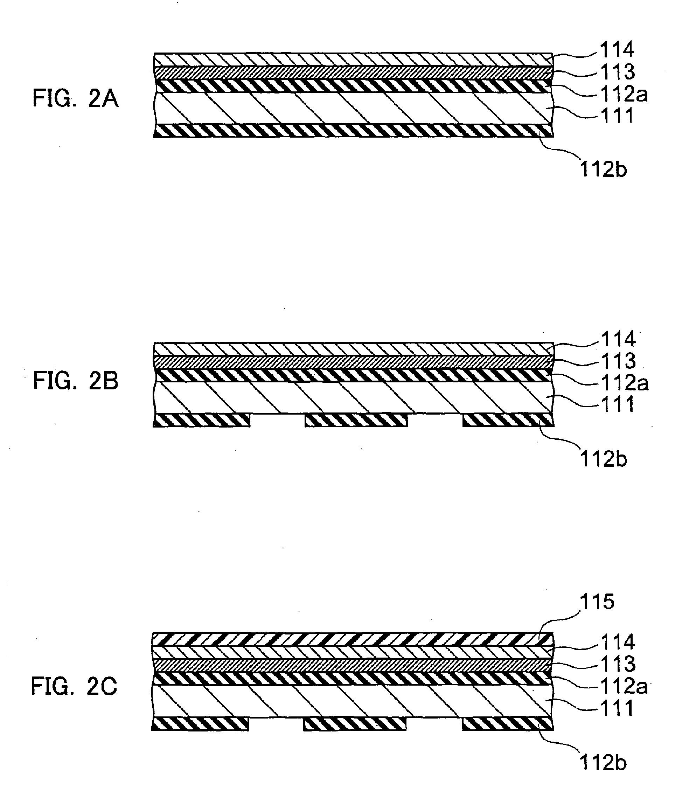

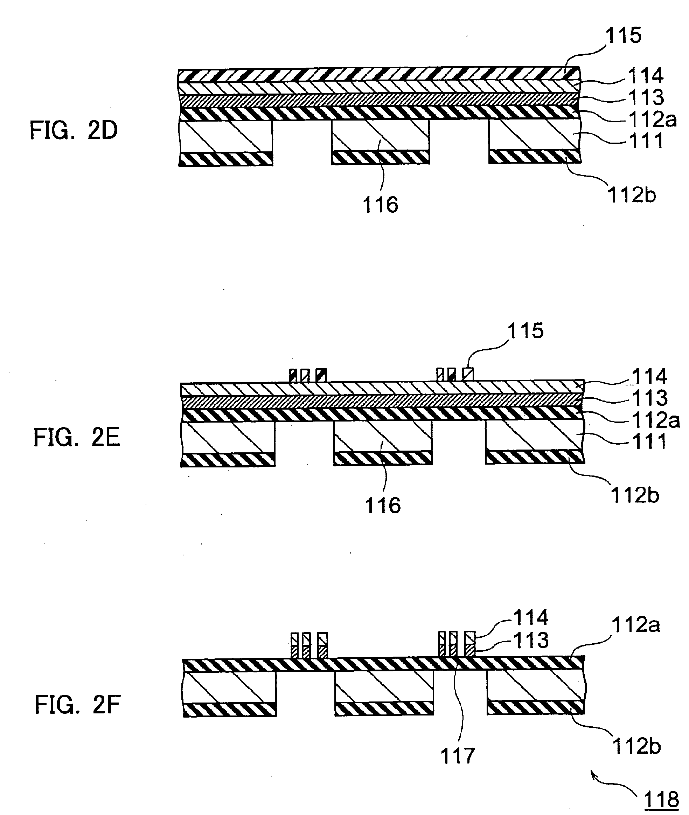

On the contrary, in the case producing the scattering membrane mask, first, as shown in Fig. 2A, a silicon nitride film 112a, 112b is formed in the both side of a silicon wafer 111 by, for example, the chemical vapor deposition. The silicon nitride film 112a in the surface side of the mask is made as a material of a membrane, the silicon nitride film 112b in the reverse side of the mask is made as an etching mask of the silicon wafer 111.

On the silicon nitride film 112a, a tungsten layer 114 is formed, for example, through a chromium layer 113. The chromium layer 113 is made to an etching-stopper layer in etching the tungsten layer 114, the tungsten layer 114 is made to a scatterer of a charged particle beam.

Next as shown in Fig.2B, the silicon nitride film 112b in the reverse side of the mask is etched, the silicon nitride film 112b in the membrane forming region is removed. Next, as shown in the Fig. 2C, a resist 115 is applied on the tungsten layer 114.

Next, as shown in the Fig.2B, the silicon layer 111 is etched as the silicon nitride film 112b is a mask, a beam 116 is formed. Next, as shown in Fig.2E, a mask pattern is drawn on the resist 115, and the resist is developed. An electron beam drawing machine is used for the drawing the mask pattern.

Next, as shown in Fig.2F, the tungsten layer 114 is etched as the resist 115 is a mask, the resist 115 is removed. Further, by etching on the chromium layer 113 as the tungsten layer 114 is a mask, a printing pattern is formed on a membrane consisting of the silicon nitride film 112a, and a scattering membrane mask 118 is formed.

To the formed scattering membrane mask 118 a charged particle beam is irradiated from the reverse side, in other words the beam 116, the pattern is printed to the wafer by the charged particle beam passing through the membrane 117 of an except portion of the scatterer, in other words the tungsten layer 114.

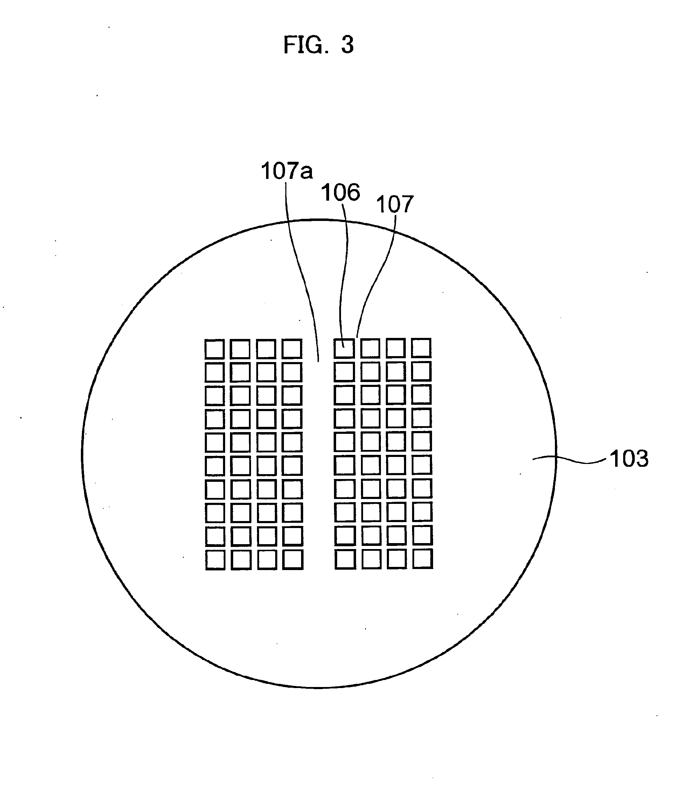

Fig.3 is a plan view of an example of a stencil mask. As shown in the Fig.3, the membrane 106 sectionalized by the beam 107 is located on the middle portion of the silicon wafer 103, in other words a supporting frame. In addition, a thick beam 107a is different from the beam 107 in the only point of width, the cross-sectional structure is common to the beam 107.

To expose accurately desired pattern on the wafer by using the stencil mask or the scattering membrane mask as mentioned above, the following each condition should be filled at the time of producing or using the mask.

The condition, first, includes controlling adequately internal stress of the membrane. In the case of not controlling adequately internal stress of the membrane, the membrane flexes and it causes a shift of the position or a strain of the pattern. Moreover, in the case of the stencil mask, since internal stress at the portion of the aperture becomes zero, depending on the pattern the stress concentration occurs in a portion of the membrane, there is a possibility that the membrane may be damaged.

The other condition includes performing vertical and accurate etching at the time of forming the pattern on the mask. In the case that the wall surface of the aperture of the stencil mask or the scatterer of the scattering membrane mask is not vertical, an electron beam and so on used for exposing scatters on the wall surface. Moreover, in the case of not processing the wall surface vertically, the thickness of the mask does not become uniform adjacent to the wall surface, the possibility that an electron beam and so on passing through the portion except the aperture may arise. Therefore, the pattern is not printed accurately. From a similar reason, improving line width uniformity or in-plane uniformity is also needed.

The other condition includes performing an accurate and quick inspection. Moreover, revising a defect inspected in the defect inspection accurately by using for example FIB is needed. FIB is an abbreviation of "focused ion beam".

Moreover, in LEEPL using a low-acceleration electron beam as a beam for exposing, the stencil mask having extremely thin membrane is used. Therefore, in particular in the portion being formed a microscopic pattern, because the mechanical intensity of the mask is insufficient, the pattern is likely to be damaged. For example, if physical impact is added to the mask at a deportation in producing or using the mask, using the mask is impossible by destructing the pattern. Even if a damage of the pattern at a permissible degree, using the mask becomes impossible by accumulating the damage in repeat of using, cleaning and deporting the mask and by occurring to a critical destruction.

The mask that becomes nonusable by the destruction of the pattern is disposed, however in the view of manufacturing cost of the mask and so on using the mask iteratively in the range of not occurring to the unacceptable pattern destruction is preferable. Therefore, the other condition needed in manufacturing and using the mask includes comprehending accurately the degree of the damage of the pattern.

Further the other condition includes preventing an adhesion of a foreign material to the mask. Multiple cleaning are performed in the manufacturing process and before using for the mask, however these cleaning process needs to clean the mask without destroying the microscopic pattern of the mask. Moreover, it is necessary not only to clean the mask, but to control the foreign materials or to detect the deposition of the contaminator by exposing.

In the inspection for confirming whether the above-mentioned each condition is satisfied, an inspection that it is necessary to destroying the mask pattern or that it is danger of destroying the mask pattern may exist. Therefore, for the mask used for exposing actually, these inspections can be performed conventionally. For performing the inspection with destroying the mask pattern, it is necessary to make a simulated mask for inspection, in other words a dummy mask, in the identical condition to the mask used actually, increasing the cost has become problematic.

### DISCLOSURE OF THE INVENTION

The present invention was made in consideration of said problems, therefore the object of the present invention is to produce the mask being possible to perform the destructive inspection without making the mask for the inspection or to perform more accurately the non-destructive inspection, or to produce the method of producing the mask.

In addition, the present invention is possible to perform the mask inspection such as the destructive inspection and so on by using the mask for exposure, the object of the present invention is to produce the method of manufacturing the semiconductor device being possible to reduce pagination of making the mask.

To accomplish the above object, a mask of the present invention is comprising a thin film for exposure that has a transmission portion and a non-transmission portion of a beam for exposure, a thick film portion that is formed around the thin film for exposure and that supports the thin film for exposure, and a thin film for inspection that is formed at a distance from said thin film for exposure in a portion of said thick film, and that has a transmission portion and a non-transmission portion of said beam for exposure. In addition, the mask is characterized preferably by comprising said thin film for inspection of which thickness and material are equal to those of said thin film for exposure.
It is preferable that said non-transmission portion is a thin film, and said transmission portion is an aperture formed on said thin film. Alternatively, said transmission portion is a thin film, and said non-transmission portion is a beam scatterer for exposure formed on said thin film. The area of said thin film for inspection may be larger than said thin film for exposure, and the flexure of said thin film for inspection may be bigger than that of said thin film for exposure. Said thin film for inspection may have said transmission portions of which line width is different each other.
Said thin film for inspection may have portions in which the density of said transmission portion is different each other. Said thin film for inspection may comprise the second vulnerable portion that the probability of pattern damage is higher than said first vulnerable portion that the probability of pattern damage is the highest in said thin film for exposure.
To accomplish the above object, a method of inspecting a mask in the present invention is characterized by a method of inspecting a mask having a thin film for exposure having a transmission portion and a non-transmission portion of a beam for exposure in a predetermined pattern and a thick film portion supporting said thin film for exposure formed around said thin film for exposure, by a thin film for inspection that is having a transmission portion and a non-transmission portion of a charged particle beam and that is formed at a distance from said thin film for exposure in a portion of said thick film portion, by preferably having a step of inspecting in said thin film for inspection of which thickness and material are equal to those of said thin film for exposure and by a step of estimating a condition of said thin film for exposure from a result of inspection in said thin film for inspection.
The inspection in said thin film for inspection may be destructive inspection. Inspection in said thin film for inspection comprises measurement of an internal stress in the bulge test. It is preferable that said transmission portion is an aperture formed in said thin film for exposure and thin film for inspection by a same etching step and a step of performing said inspection comprises a step of cutting a spot of irradiating of a focused ion beam by irradiating a focused ion beam to a portion of said non-transmission portion in said thin film for inspection and a step of evaluating an etching cross sectional shape by observing the cutting surface with a microscope. Said transmission portion of which line width and/or interval are different is formed in said thin film for inspection, and line width uniformity of an etching is examined further. Alternatively, said thin film for inspection is formed at several multiple spot, and an in-plane uniformity of an etching is examined further.

It is preferable that said transmission portion is an aperture formed in said thin film for exposure and thin film for inspection by a same step. A step of performing inspection in said thin film for inspection comprises a step of obtaining a fluctuation of a line width and a corner rounding of when an aperture formed actually is compared with a design data of a thin film for inspection in said thin film for inspection in which said transmission portion of which line width and/or interval are different is formed. A step of estimating a condition of said thin film for exposure comprises a step of correct a pattern of an aperture formed actually in said thin film for exposure by using a fluctuation of a line width and a corner rounding obtained in said thin film for inspection and a step of detecting a defect of a pattern of a thin film for exposure by referring a corrected data and a design data of a thin film for exposure. Further, it is preferable that a defect is corrected by irradiating a focused ion beam to a defect of a pattern detected in said thin film for exposure, and collimating of a focused ion beam is performed in thin film for inspection.

It is preferable that a step of performing inspection in said thin film for inspection comprises a step of confirm presence or absence of destruction of a pattern formed in said thin film for inspection in a narrower line width of a pattern formed sat a portion that the probability of a pattern damage is the highest in said thin film for exposure. Alternatively, the step comprises a step of confirming presence or absence of destruction of a pattern of a portion that said transmission portion is formed in said thin film for inspection in higher density of said transmission portion that the probability of a pattern damage is the highest in said thin film for exposure. In the case of confirming destruction of a pattern in said thin film for inspection, said thin film for exposure is estimated as a nonusable condition.

Herewith, even inspection with destruction of a pattern can be possible to perform with a mask used for exposure. Moreover, since to perform inspection about a transmission portion formed in a step identical to a transmission portion used for exposure actually can be possible, to evaluate more accurately a condition of a transmission portion used for exposure.

To accomplish the above object, a method of producing a semiconductor device of the present invention is characterized by performing a lithography process by using a thin film for exposure of a mask comprising a thin film for exposure having a transmission portion and a non-transmission portion of a beam for exposure in a predetermined pattern, a thick film portion that is formed around said thin film for exposure and support said thin film for exposure, and a thin film for inspection in which is formed at a distance from said thin film for exposure at a portion of said thick film, that is having a transmission portion and a non-transmission portion of said beam for exposure and that has thickness and material preferably equal to those of said thin film for exposure.

According to a method of producing a semiconductor device of the present invention using a mask of the present invention, since a mask of the present invention that a condition of a thin film for exposure can be comprehended by a thin film for inspection for lithography, TAT, that is to say turn around time, of producing a mask is reduced in producing a semiconductor device and the cost is also reduced.

### BREIEF DESCRIPTION OF THE DRAWING

Fig. 1A to Fig. 1F are cross-sectional views showing a manufacturing process of a method of manufacturing a stencil mask.
Fig. 2A to Fig. 2F are cross-sectional views showing a manufacturing process of a method of manufacturing a scattering membrane mask.
Fig. 3 is a plan view of a conventional mask.
Fig. 4 is a plan view of a mask of the present invention.
Fig. 5 is a schematic view of a measurement device of internal stress of a membrane using for inspection of a mask of the present invention.
Fig. 6A and Fig. 6B are showing examples of patterns formed in a membrane for inspection of a mask of the present invention.
Fig. 7 is a perspective view showing a cross sectional shape of a mask.
Fig. 8A is showing an example of a design data of a pattern, Fig. 8B is an example of a pattern obtained actually from a design data of Fig. 8A.
Fig. 9 is an example of a pattern formed on a membrane for inspection of a mask of the present invention, and is showing a pattern being possible to use collimating a focused ion beam.
Fig. 10A and Fig. 10B are views showing examples of positions to locate a pattern that is weak for impact.
Fig. 11 is a view showing a pattern damage probability of a membrane for exposure and a membrane for inspection of the present invention.
Fig. 12 is a view showing an example of a work flow of a method of manufacturing a semiconductor device of the present invention.

### BEST MODE FOR CARRYING OUT THE INVENTION

Embodiments of a mask of the present invention, a method of inspecting the same and a method of manufacturing a semiconductor device will be explained below by referring the drawings.

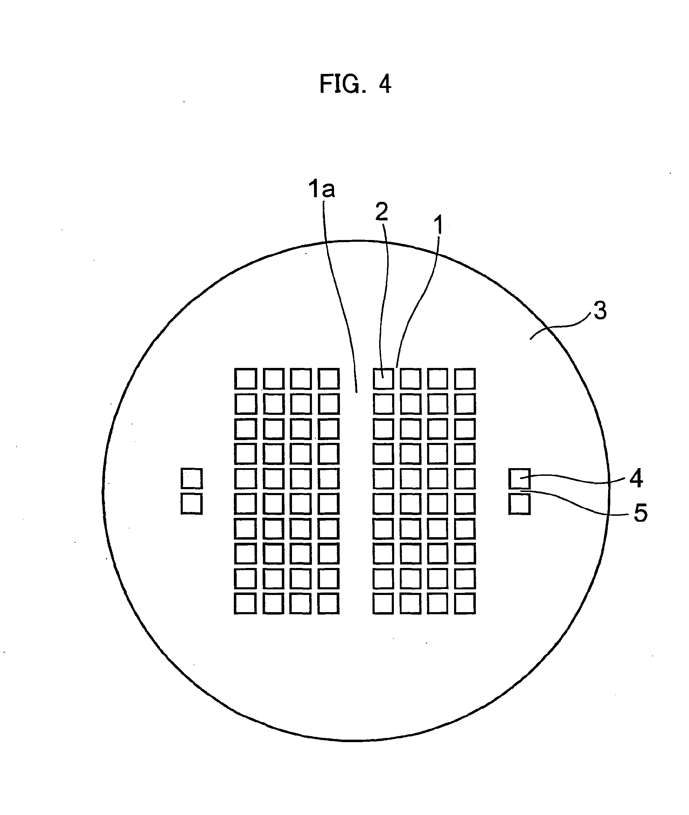

Fig. 4 is a plan view showing an example of a stencil mask of this embodiment. As shown in Fig. 4, a thin film for exposure 2, in other words a membrane for exposure, sectionalize by a beam 1 is located in the middle portion of a silicon wafer 3 as a thick film portion, in other words a supporting frame. A thick beam 1a is different from the beam 1 in the only point of width, a cross-sectional structure is common to the beam 1.

The stencil mask of this embodiment has a thin film for inspection of a small partition 4, in other words a membrane for inspection, at a region not used for exposure actually, in other words a region that a charged particle beam is not irradiated at the time of exposure. The membrane for inspection 4 is formed in a process that is identical to a membrane 2 used for actual exposure. On the membrane for inspection 4, an aperture is formed as a pattern for inspection in a process that is identical to a process that an aperture is formed on the membrane 2 in a predefined pattern. The beam 5 sectionalizing the membrane for inspection 4 has a cross-sectional structure that is similar to the beam 1 sectionalizing the membrane for exposure 2.

### EMBODIMENT 1

This embodiment relates to a method of monitoring internal stress of a membrane using a mask of the present invention. For the method of measuring internal stress of a membrane constructing the stencil mask, two methods such as (1) a method of measuring flexure of the membrane and calculating internal stress based on quantity of flexure, and (2) a method of measuring internal stress directly, are considered.

In the case that internal stress of the membrane is not adjusted adequately for the stencil mask, the membrane flexes, and accuracy of position of the pattern is reduced. Alternatively for a proximity exposure method such as LEEPL, if the flexure of the membrane increases, the membrane and the wafer are in touch, hence there is the possibility that the mask is destroyed.

Therefore, by using the membrane for inspection 4 shown in Fig. 4, quantity of flexure of the membrane is surveyed, this method is, that is to say, the method of said (1). By performing this measurement for at the time of completion of the mask blanks (the time after forming the membrane and the beam by removing a portion of the wafer, the time before forming an aperture on the membrane, refer to Fig. 1C) if assessing whether to advance to the next process, the mask blanks that the adjustment of internal stress is insufficient can be eliminated. For the measurement of quantity of flexure of the membrane for inspection 4, for example a height measuring machine using a laser can be used.

Since quantity of flexure of the membrane is possible to measure by non-destructive inspection, if comparing with an inspection assuming a destructive inspection, setting the membrane for inspection has few advantages. However, for example, if forming the membrane for inspection 4 having larger area than the membrane for actually exposure 2, since quantity of flexure becomes larger, the measurement of flexure becomes easier. Alternatively, for measuring accurately quantity of flexure in a middle portion of the membrane, an alignment mark in the middle portion of the membrane can be set.

Even quantity of flexure of the membrane is in the allowance range at the time of completion of the mask blanks, if forming an aperture on the membrane at a process afterward, quantity of flexure of the membrane can increase. Therefore, not only at the time of a completion of the mask blanks but also just before implementing the mask to an exposing devise, performing the measurement of quantity of flexure by using the membrane for inspection 4 is preferable.

In the case of a proximity exposing method such as LEEPL, after the mask passes through a gap sensor and an interval between the mask and the wafer is measured by the gap sensor, the mask is located just below an electron beam microscope tube. Since the mask passes from an end of the gap sensor, if the membrane for inspection 4 being set near the periphery is made to pass the gap sensor before the membrane for actually exposure 2, a danger of touch of the membrane for actually exposure 2 and the wafer can be sensed and be avoided.

In the case that since quantity of flexure of the membrane is much, the gap sensor assesses that the interval between the mask and the wafer is narrow at an impermissible degree, the mask is assessed defective or by performing stress adjustment of the membrane to the mask taken out of the exposing device again, quantity of flexure is made smaller. Alternatively, if the exposure accuracy is in the allowance range, the mask can be relocated just below an electron beam microscope tube after changing the configuration of the exposing device so that the interval between the mask and the wafer is expanded.

In the case of measuring internal stress of the membrane directly, that is to say the case of the method of said (2), the membrane is coercively transformed by using barometric pressure or radio-frequency wave, internal stress is determined from the relationship between a load to the membrane and a amount of deformation of the membrane (refer to "Micromachining and Mechatronics" written by Esashi Masayoshi, published by Baihuukan). In the case of transforming coercively the membrane, there is a possibility that the membrane is destroyed or the pattern is displaced irreversibly.

Therefore, said measurements were not performed conventionally for the mask for exposure, internal stress was measured by a dummy mask that was made in the identical condition to the mask for exposure. Alternatively, since internal stress of the membrane will change if the ion implantation to the membrane is performed, a similar stress adjustment was only performed for the mask for actually exposure, after a stress adjustment by the ion implantation and so on to the dummy mask was performed and a condition that internal stress was optimized was beforehand examined.

As mentioned above, since the measurement of internal stress was not performed for the mask for actually exposure and a dummy mask or multiple samples having different internal stress were made, it triggered to enlarge the manufacturing cost of the mask and TAT. Further, depending on process stability such as the ion implantation for adjusting the stress, desired stress adjustment could be performed and there was a possibility to reduce a yield of the mask.

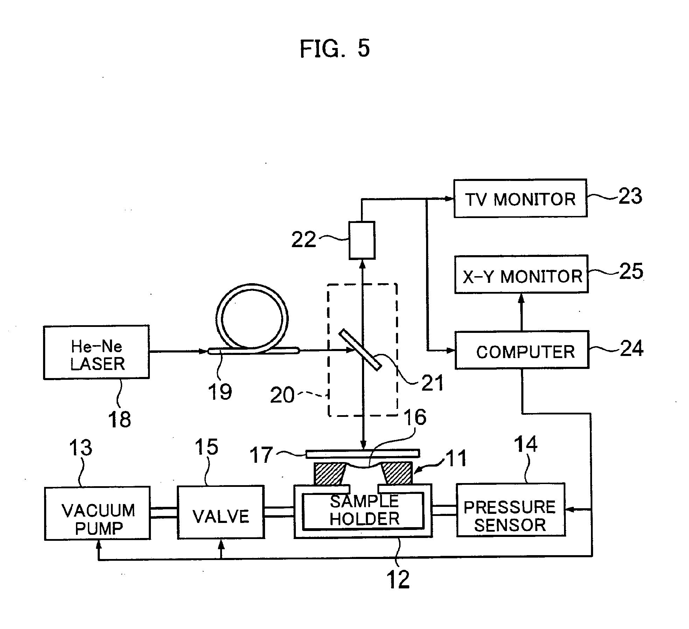

According to the mask of this embodiment, to measure directly internal stress of the membrane by using the membrane for inspection is possible. Internal stress of the membrane can be directly measured with the bulge test. A schematic view of the bulge test is shown in Fig. 5. The method of measuring internal stress by the bulge test is disclosed in Japanese Unexamined Patent Publication No.1989-237430 or Japanese Unexamined Patent Publication No.2000-329669.

As shown in Fig. 5, a mask 11 is fixed on a hollow sample holder 12. Inside of the sample holder 12 is evacuated with a vacuum pump 13. The degree of vacuum is monitored with a pressure sensor 14 and controlled to the desired degree of vacuum by adjusting with a valve 15.

In the case of a device shown in Fig. 5, a transformation of a membrane 16 is measured by the number of interference patterns of the light being arisen at a gap between an optical glass 17 and the membrane 16. For a light source, for example a He-Ne laser 18 is used, a laser is lead in a microscope 20 by a single-mode fiber optic 19.

A laser is reflected at a half mirror 21 in the microscope 20, this laser is irradiated to the optical glass 17 and the membrane 16. A picture of the interference pattern is taken with a CCD camera 22 and is sent to a TV monitor 23 and a computer 24. An X-Y monitor 25 at the point of irradiating the laser, the pressure sensor 14, the valve15 and the vacuum pump 13 is controlled with the computer 24.

As the method of make the membrane 16 to transform, except for using the vacuum pump 13 as shown Fig. 5, there is a way of using electrostatic force that is operating between an electrode being located below the membrane and the membrane, however, the way that the vacuum pump is used is generally simple. By controlling adequately to measure directly internal stress of the membrane with using the above-mentioned device, a shift of a pattern position by flexure of the membrane is avoided and the pattern is exposed with a high degree of accuracy.

### EMBODIMENT 2

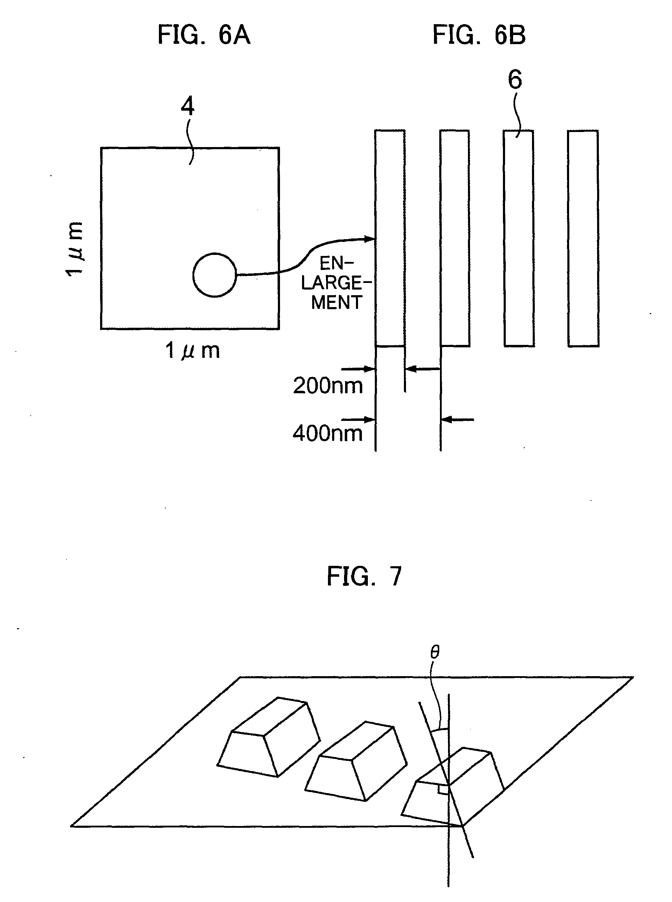

This embodiment relates to a method of inspecting a cross sectional shape by using a mask of the present invention. In this embodiment, a pattern suitable for observation of a cross sectional shape is located on a membrane for inspection 4 of a stencil mask shown Fig. 4. An example of such a pattern is shown in Fig. 6A and Fig. 6B.

Fig. 6A is a view that the membrane for inspection 4 in Fig. 4 is enlarged, Fig. 6B is a view that a portion of the membrane for inspection 4 in Fig. 6A is enlarged. As shown in Fig. 6A and Fig. 6B, as a pattern for observation of a cross sectional shape, for example a line-and-space pattern 6 having a line width of 200 nm and a pitch of 400 nm in a region of 1 by 1 µm square. A process that an aperture is formed with the line-and-space pattern 6 on the membrane for inspection 4 is identical to a process that an aperture is formed with a predetermined pattern on the membrane for exposure 2.

Next, by irradiating a portion of the membrane for inspection 4 with a FIB, the pattern 6 is cut off. Here, as a FIB, for example a gallium ion beam is used.

Next, a stencil mask is taken on a stage having a tilt mechanism, a cross section of the membrane cut by a FIB is observed with a SEM, scanning electron microscope. From a SEM image obtained this time, a taper angle of the pattern shown in Fig. 7 can be obtained.

The process from a cutting of the pattern with the above FIB irradiating to the observation of a cutting surface is possible to be performed with one device, for example by using SMI-9800 (made by Seiko Instruments Inc.). Since these inspection processes are destructive inspections, it is not possible to perform with a membrane for exposure.

By using the mask of the present invention, without making a dummy mask, a taper angle of the pattern is measured with a high degree of accuracy. Therefore, it can be possible to expose a pattern with a high degree of accuracy. Moreover, the cost for making a dummy mask does not increase.

### EMBODIMENT 3

This embodiment relates to method of inspecting line width uniformity and in-plane uniformity by using a mask of the present invention. Line width uniformity and in-plane uniformity of the pattern formed in an etching process change depending on line width or density of the pattern. A phenomenon that an etching speed shows a dependence on an etching area and an etching speed lowers as an etching area increases is called the loading effect.

Moreover, a phenomenon that an etching speed lowers as a line width of a pattern, in other words a diameter of an aperture, is reduced and a phenomenon that an etching speed does not become uniform when a pattern having an identical line width exists at different density are called micro-loading effect.

A membrane of a stencil mask and a scatterer of a charged particle beam of a scattering membrane mask are processed by an etching that a resist is used as a mask. Therefore, except for a line width fluctuation arising from the above-mentioned etching process, there is a line width fluctuation arising from a resist forming process.

If a resist pattern that a line width is identical and a pattern interval is different is formed, a resist line width fluctuates depending on a pattern interval, and a variation of a line width or an in-plane uniformity changes depending on a resist line width. Moreover, since a pattern edge roughness changes depending on a line width or a pattern interval, the pattern edge roughness does not become uniform also in the membrane that the pattern edge roughness is taken over by the etching.

For checking whether impacts of the pattern edge roughness, the loading effect or the micro-loading effect are in the allowance range, for example an observation with a SEM that is identical to the embodiment 2 is performed. On the membrane for inspection 4 of the mask of the present invention, the line-and-space that a line width or a pattern interval is changed is formed. By measuring a resist line width before the etching process or a pattern line width after the etching with a SEM and so on, line width uniformity or in-plane uniformity can be inspected.

Moreover, by setting the membrane for inspection 4 in multiple spots except for the membrane for exposure 2 and forming a similar pattern for inspection on the membrane for inspection 4, a CD distribution, that is to say a critical dimension distribution within the mask surface can be monitored.

### EMBODIMENT 4

This embodiment relates to a reference image making at the time of performing a defect inspection with a mask of the present invention. As a defect inspection of a mask, there are a method comparing adjacent tips, in other words die-to-die inspection and a method comparing a mask pattern with a design data, in other words die-to-database inspection or DB inspection. In die-to-die inspection, defects can be detected in the case that the compared tips have defects of a same shape, however in die-to-database inspection, such a problem does not occur, hence an inspection by die-to-database inspection is likely to perform.

In a defect inspection, a reference image is made from a pattern on the mask by using an optical system of an inspection device. On the contrary, a reference image is also made from a design data, defects are detected by comparing these reference images. In the actually mask, since the pattern is formed after formation of a resist pattern with a drawing machine, etching and removing the resist, a pattern that is identical to a design data completely is not obtained. Concretely, a line width of a pattern fluctuates and a corner rounding occurs.

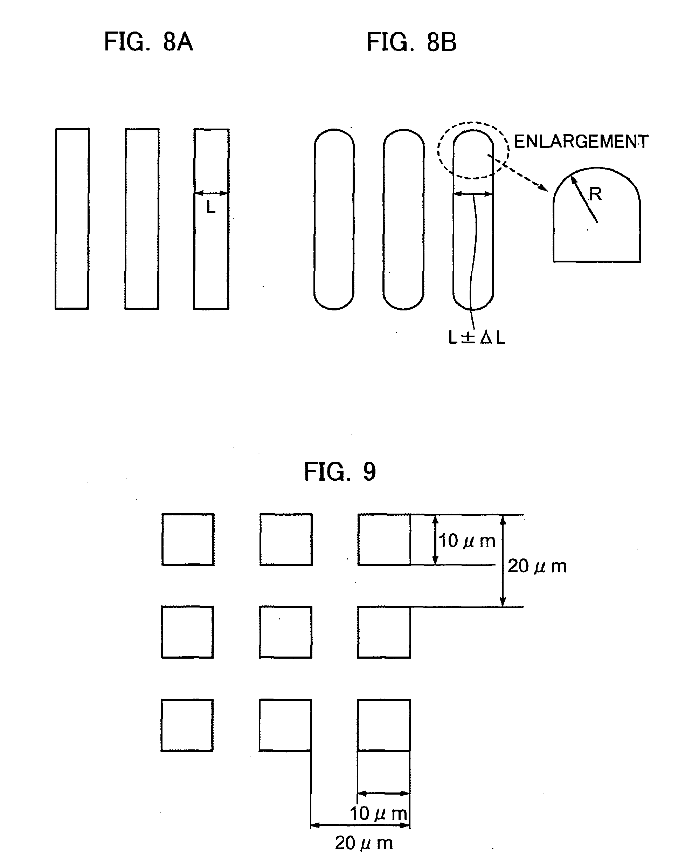

In Fig. 8A and Fig. 8B, an example of a fluctuation of a line width after forming the pattern and an example of a corner rounding are shown. Fig. 8A is a design data and a line-and-space pattern having the line width L. Fig. 8B is an example of a pattern that is formed on the mask based on the design data of Fig. 8A. The line width in Fig. 8B is L±ΔL, and the corner of the pattern is a curve having a curvature radius R.

In an inspection by die-to-database inspection, while a mismatch between a design data by a fluctuation of a line width or a corner rounding and a pattern on the mask is allowed, it is necessary to detect controversial defects. Therefore, by adding compensation about a line width or a corner rounding to an image of the mask that is obtained in an optical system of the inspecting device, a reference image that is similar to the reference image of the design data is made.

At this time, if a parameter value that is correcting a line width or a corner rounding is accurate, since a reference image that is similar to the reference image of the design data is obtained, it is possible to perform comparing reference images and to detect defects with a high degree of accuracy. Consequently, on the membrane for inspection, line-and-spaces that have different line width or density each other and so on are formed, these fluctuations of line width or a cross sectional shapes and so on are measured by the method that is similar to for example the embodiment 2 with using a SEM.

Instead of such a destructive inspection, a measurement of a line width or a corner rounding may be performed in nondestructive. By setting a parameter value for making reference image based on a line width or a corner rounding on the membrane for inspection, since not only the cost or the labor for making a dummy mask is not necessary , but a parameter value on a membrane made in the process that is identical to the membrane for actual exposure is available, the parameter value can be optimized with a high degree of accuracy. Therefore, performing comparing reference images at short times and detecting defects with a high degree of accuracy become possible.

### EMBODIMENT 5

This embodiment is an example that a mask of the present invention is applied for correcting defects with using a FIB. First, on the membrane for inspection 4 of a stencil mask shown in Fig. 4, a pattern shown in Fig. 9 is located. As shown in Fig. 9, a pattern of 10 by 10 µm square is located in a 3×3 matrix in the interval of 10 µm. The pattern of the membrane for inspection 4 is formed in a process that is identical to the pattern of the membrane for exposure 2.

After making the mask, the defects detected in defect inspection are corrected by irradiating a FIB. There are two kinds of defect, black and white. The black defect is a defect that a membrane, or a charged particle beam scatterer in the case of a scattering membrane mask, is left at a portion of the pattern to be an aperture. The pattern that should be etched is left without etching because foreign materials and so on adhere except for the pattern, hence the black defect arises. On the other hand, the white defect is a defect that an aperture is formed except for the pattern. The pattern that should be left is etched erroneously because the resist pattern is missing and so on, hence the white defect arises.

Generally, the black defect is corrected by a process with a gallium ion beam, in other words milling, or a GAE, gas assist etching, that etches effectively by erupting gas on the sample. On the contrary, the white defect is corrected by forming a carbon thin film in the irradiating position by irradiating a gallium ion beam in the organic gas atmosphere such as pyrene and so on.

Before performing correction by irradiating an ion beam to defect spots, collimating of the ion beam, in concrete terms focusing or astigmatism adjustment, is performed. This collimating is performed by detecting a secondary ion or a secondary electron emitted at the time of irradiating an ion beam to the mask. However, it is preferable that the residual volume of gallium ion in the mask is made to be minimal.

For example, in the case that a membrane material of the stencil mask is silicon, if residual metal such as gallium exists, there is a possibility that contact-potential difference arises by touch between materials of other kind. If in the electron beam lithography the mask is taken a charge, the position of an electron that enters later may deviate, this is called charge-up. Since the contact-potential difference by the residual of gallium triggers the charge-up occurring, irradiance of a gallium ion beam to the membrane for exposure is kept to the minimum.

In the case of performing correcting defects with the mask of the present invention, by using the pattern as shown in Fig. 9 on the membrane for inspection, collimating is performed. By irradiating a gallium ion beam to the pattern shown in Fig. 9, an adjustment is performed so that an edge of an obtained secondary ion image becomes clear. Afterward, by moving a stage of the mask and irradiating a gallium ion beam to defect spots, correcting is performed.

As mentioned above, by performing collimating of an ion beam with the membrane for inspection set aside from the membrane for exposure, it may be possible to reduce the residual volume of a gallium in the membrane for exposure. Herewith, the charge-up at the time that the mask is used for exposure is avoided, the mask pattern is printed accurately on the wafer.

### EMBODIMENT 6

This embodiment relates to a method of monitoring damage of the mask by repeating use, freighter or cleaning. As for the stencil mask of equal scale as being used in LEEPL, since a microscopic pattern is formed in an equal scale on the ultra thin membrane, the pattern is damaged by a physical shock.

The pattern damage by a shock in the process of manufacturing the mask is detected in the defect inspection just after completion of the mask, however, presence or absence of the pattern damage by a shock on the way of freighter of the shipped mask, in handling for using the mask in the exposing devise or in cleaning the mask used for exposure is necessary to be checked as needed. Moreover, as a stencil mask of equal scale having ultra thin membrane, the roughness of the surface of the membrane by chemical solution at the time of the mask cleaning is noticeable. The roughness of the surface of the mask triggers fluctuation of the pattern size or the pattern destruction.

The mask that the pattern is destroyed is disposed because it is nonusable. If the pattern damage is in the allowable degree, the mask is used repeatedly for exposure. Therefore, it is necessary to comprehend accurately the degree of the pattern damage. In the case that the mask is used repeatedly, the mask is cleaned if necessary.

In the case of the photo-mask, foreign material or contamination is reduced with the pellicle as a protective mask, however, in lithography using a low-accelerated electron such as LEEPL, since an electron beam is shielded in the portion except for apertures, a protective mask corresponding to the pellicle cannot be set. Therefore, since it is easily contaminated at the time of exposure, cleaning is needed at the time of not only the process of the mask but using the mask for exposure.

In this embodiment, a microscopic pattern that is equal to the pattern of which line width and/or interval are the most microscopic in the actual device pattern or more microscopic pattern than it is located on the membrane for inspection 4 of the stencil mask in Fig. 4. That is to say, when the portion that line width is the smallest, pattern density, in other words density of the portion being made as an aperture, is the highest or both of the above conditions is fulfilled is defined as the first vulnerable portion, the second vulnerable portion that is more easy to destroy than the first vulnerable portion is formed on the membrane for inspection 4.

In the second vulnerable portion of the membrane for inspection 4, the pattern that is easy to destroy, such as for example a microscopic line-and-space pattern, or a pattern of a shape of a cantilever beam called as leaf pattern and so on, is located. Since such patterns are easy to being damaged because the mechanical strength of such patterns is weak, it is suitable to monitor accumulation of damage by freighter, using repeatedly or cleaning.

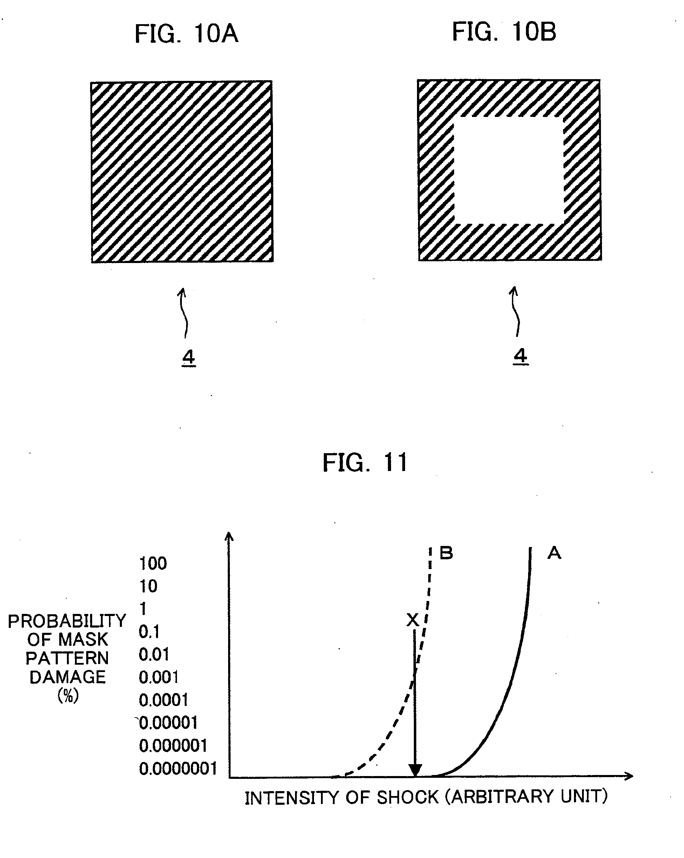

The damage of the pattern can be observed by using for example a SEM, however, it is possible to assess the timing of disposal of the mask with eyes more simply. In this case, as shown in Fig. 10B with diagonal lines, the second vulnerable portion is formed in the portion along the boundary between the silicon wafer 3 and the membrane for inspection 4.

If the second vulnerable portion is destroyed, the membrane for inspection 4 is felt off in the size which is the similar size of the membrane 4. The size of the membrane for inspection 4 is for example of 1 by 1 mm square, it is adequately possible to confirm falling out of the membrane for inspection 4 with eyes. Therefore, the mask that is possible to be destroyed the pattern in the membrane for exposure 2 can be eliminated certainly without performing inspection using device such as a SEM and so on.

In addition, in the case that the membrane for inspection 4 is larger, if not approximately aperture of the membrane for inspection 4 but a portion is felt off, falling off can be confirmed with eyes. Therefore, the second vulnerable portion is not necessary to be formed aperture of the membrane for inspection 4 or adjacent to the boundary of the membrane for inspection 4. It is enough that the size that the second vulnerable portion and the portion that is surrounded by the same are joined can be confirmed with eyes.

As shown in Fig. 11 typically, if the probability of the mask pattern damage B of the second vulnerable portion in the membrane for inspection 4 is higher than the damage probability of the mask pattern A of the first vulnerable portion in the membrane for exposure 2, danger of the pattern damage in the membrane for exposure 2 can be predicted from the damage condition of the membrane for inspection 4 before the pattern damage arises in the membrane for exposure 2. For example on the intensity of shock X shown in Fig. 11, since the pattern damage is detected in the membrane for inspection 4, however, in the membrane for exposure 2 the pattern damage is considered to arise, a margin to the pattern damage is given and the mask can be disposed.

However, if difference between the possibility of the mask pattern damage A and the possibility of the mask pattern damage B is enlarged and a margin is enlarged, the number of times that the mask is repeatedly used reduces. Therefore, the correlation between the intensity of shock and the possibility of the mask pattern damage as shown in Fig.11 is investigated in advance about the pattern of several kinds.

As mentioned above, when the membrane for inspection 4 is destroyed, if the membrane for exposure 2 is usable, exposure can be performed with the mask. According to this embodiment, by comprehending the degree of the pattern damage by shock in freighter or cleaning and so on, timing of disposal of the mask can be assessed accurately.

### Embodiment 7

This embodiment relates to a method of monitoring contamination of the mask. Since a protective mask such as a pellicle can be set in the stencil mask for the low-accelerated electron beam, there is possibility that foreign materials that cause trouble to exposure adhere to the mask by handling at the time of using the mask. However, to perform detailed foreign material inspection in the aperture region used for exposure is not realistic because enormous time is required.

Consequently, a detailed inspection is preformed by using the membrane for inspection 4 shown in Fig. 4, and the contamination condition of the membrane for exposure 2 is estimated based on this result. On the membrane for inspection 4, a line-and-space pattern of which line width and interval are changed and so on is formed. Performing the inspection in detail by using a SEM-type defect inspection device and so on about the membrane for inspection 4, the mask contamination is inspected at the short time. By monitoring increase or migration of foreign materials before and after handling at the time of using the mask in the membrane for inspection 4, the presence or the absence of foreign material affecting exposure in the membrane for exposure 2 can be estimated.

### EMBODIMENT 8

This embodiment relates to a method of monitoring the fluctuation of a line width by the deposition of contaminants on the mask. Since a protective mask such as a pellicle cannot be set in the stencil mask for the low-accelerated electron beam, at the time of exposure, by irradiating an electron to the mask, contaminants are deposited gradually on the mask by the gas that is generated in the exposing device.

If these contaminants are deposited on the sidewall of the mask pattern, the pattern line width becomes thin, the pattern edge roughness gets worse. Therefore, an effect arises on the pattern printing. Moreover, contaminants deposited at a spot distant from the pattern do not affect line width of the mask pattern, however, contaminants causes charge-up at the time of exposure and fluctuates line width of the pattern printed. From the above, to monitor depositing contamination the mask and to estimate an effect to exposure is important.

Therefore, on the membrane for inspection 4 of the stencil mask shown in Fig. 4, a line-and-space pattern of which line width and interval are different is formed. About the deposition of the contaminant to the mask, to measure directly line width of the pattern of the membrane for inspection 4 by exposure, or to measure line width printed by printing the pattern of the membrane for inspection 4 on the wafer by exposure, the above both ways may be sufficient. However, in the case of measuring line width of the exposed pattern, the pattern of the membrane for inspection 4 is exposed at a spot that does not affect the electric property of the device.

As mentioned above by monitoring contamination of the mask, timing of cleaning or disposal of the mask can be estimated. Moreover, by monitoring the contamination condition in a similar method before and after cleaning the mask, the effect of cleaning can be monitored.

### EMBODIMENT 9

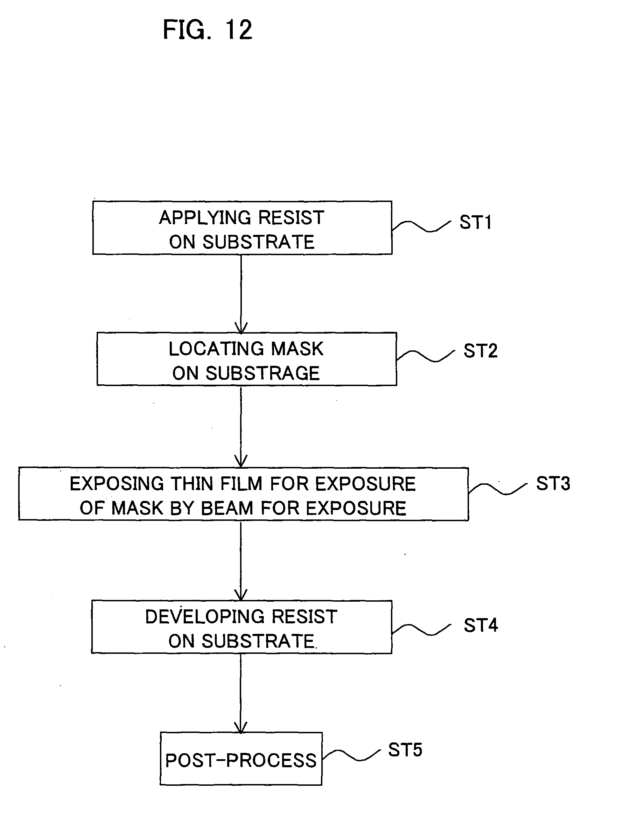

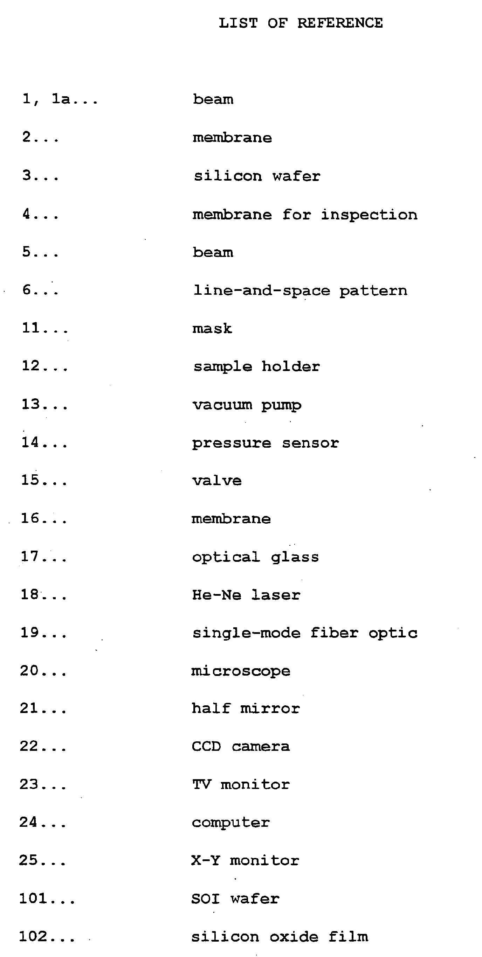

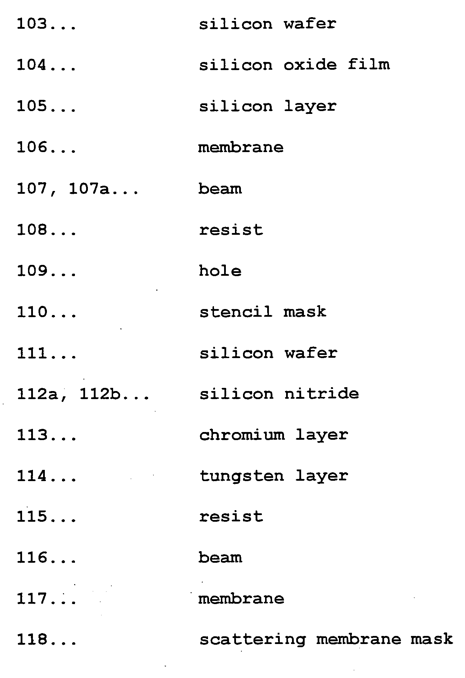

In Fig. 12 an example of a method of producing a semiconductor device of this embodiment is shown. In the step 1 (ST1), a resist is applied on the substrate. In the step 2 (ST2), the mask is located on the substrate. Here, as the mask, the mask of the present invention having a thin film for exposure that has a transmission portion and a non-transmission portion of a beam for exposure, a thick film portion that is formed around the thin film for exposure and that supports the thin film for exposure, and a thin film for inspection that has a transmission portion and a non-transmission portion of a beam for exposure and that has the thickness and the material equal to those of a thin film for exposure is used.

In the step 3 (ST3), the thin film for exposure of the mask is exposed with a beam for exposure. In the step 4 (ST4), a resist on the substrate is developed. In the step 5 (ST5), as a post-process for example, a process of the ion implantation, a process of dry etching and so on are performed, the semiconductor device is produced.

Since the condition of the thin film for exposure can be comprehended with the thin film for inspection, a yield in producing the mask of the present invention is high and the delivery time of the mask is shortened. Therefore, according to the method of producing the semiconductor device of the present invention used the mask of the present invention, shortening TAT of in producing the mask can be expected. Moreover, without producing separately the mask for inspection, since it is possible to perform various kinds of inspection containing destructive inspection with the mask used for exposure, the cost of producing the semiconductor device can be reduced.

The embodiments of the mask of the present invention, the method of inspecting the same and the method of producing a semiconductor device is not limited to said explains. For example, in the above explain an example of a stencil mask is shown, however by setting the thin film for inspection in a similar way in the region that is not used for exposure of the scattering membrane mask, various kinds of inspection can be performed.

Moreover, the mask of the present invention and the method of inspecting the same are not limited to the stencil mask for the electron beam lithography and can be applied to the mask for the ion beam lithography and the stencil mask or the membrane mask for the lithography using the other beam for exposure such as an X-ray, EUV, in other words extreme ultraviolet, and so on. Moreover, the mask of the present invention and the method of inspecting the same can be also applied to the stencil mask used for the other process such as the ion implantation and so on. Note that the present invention is not limited to said embodiments and includes modifications within the scope of claims.

According to the mask of the present invention and the method of inspecting the same and the method of producing a semiconductor device, without making the mask for inspection separately the mask for exposure, it will be possible to perform accurately inspection of the mask containing destructive inspection.

## Claims

1. A mask comprising:
a thin film for exposure that has a transmission portion and a non-transmission portion of a beam for exposure in a predetermined pattern;
a thick film portion that is formed around said thin film for exposure and that supports said thin film for exposure; and
a thin film for inspection that is formed at a distance from said thin film for exposure in a portion of said thick film, and that has a transmission portion and a non-transmission portion of said beam for exposure.

2. A mask as set forth in claim 1, wherein
thickness and material of said thin film for inspection are equal to those of said thin film for exposure.

3. A mask as set forth in claim 1, wherein
said non-transmission portion comprises a thin film, and said transmission portion comprises an aperture formed in said thin film.

4. A mask as set forth in claim 1, wherein
said transmission portion comprises a thin film, and said non-transmission portion comprises a beam scatterer for exposure formed on said thin film.

5. A mask as set forth in claim 1, wherein
the area of said thin film for inspection is larger than said thin film for exposure, and the flexure of said thin film for inspection is bigger than that of said thin film for exposure.

6. A mask as set forth in claim 1, wherein
said thin film for inspection has said transmission portions of which line width is different each other.

7. A mask as set forth in claim 1, wherein
said thin film for inspection has portions in which the density of said transmission portion is different each other.

8. A mask as set forth in claim 1, wherein
said thin film for exposure comprises a first vulnerable portion that the probability of pattern damage is the highest in said thin film for exposure, and;
said thin film for inspection comprises a second vulnerable portion that the probability of pattern damage is higher than said first vulnerable portion.

9. A mask as set forth in claim 8, wherein
said second vulnerable portion comprises a pattern of which line width is narrower than a pattern of said first vulnerable portion.

10. A mask as set forth in claim 8, wherein
the density of said transmission portion of said second vulnerable portion is higher than the density of said transmission portion of said first vulnerable portion.

11. A method of inspecting a mask having a thin film for exposure having a transmission portion and a non-transmission portion of a beam for exposure in a predetermined pattern and a thick film portion that supports said thin film for exposure and that is formed around said thin film for exposure, comprising:
a step of performing inspection in a thin film for inspection that is formed at a distance from said thin film for exposure in a portion of said thick film portion and that is having a transmission portion and a non-transmission portion of a charged particle beam, and;
a step of estimating a condition of said thin film for exposure from a result of inspection in said thin film for inspection.

12. A method of inspecting a mask as set forth in claim 11, wherein
said thin film for inspection of which thickness and material are equal to those of said thin film for exposure is used.

13. A method of inspecting a mask as set forth in claim 11, wherein
inspection in said thin film for inspection comprises destructive inspection.

14. A method of inspecting a mask as set forth in claim 11, wherein
a step of performing inspection in said thin film for inspection comprises a step of measuring quantity of flexure of said thin film for inspection, and;
a step of estimating a condition of said thin film for exposure comprises a step of measuring quantity of flexure of said thin film for exposure.

15. A method of inspecting a mask as set forth in claim 11, wherein
a step of performing inspection in said thin film for inspection comprises a step of inspecting internal stress in the bulge test, and;
a step of estimating a condition of said thin film for exposure comprises a step of estimating internal stress of said thin film for exposure.

16. A method of inspecting a mask as set forth in claim 11, wherein
said transmission portion comprises an aperture formed in said thin film for exposure and thin film for inspection by a same etching step;
a step of performing inspection in said thin film for exposure comprises a step of cutting a portion of said non-transmission portion of said thin film for inspection and observing an etching cross sectional shape of said aperture in a cut surface, and;
a step of estimating a condition of said thin film for exposure comprises a step of estimating an etching cross sectional shape of said aperture of said thin film for exposure.

17. A method of inspecting a mask as set forth in claim 16, wherein
a step of performing inspection in said thin film for inspecting comprises a step of measuring line width uniformity of an etching in said thin film for inspection in which said transmission portion of which line width and/or interval are different is formed, and;
a step of estimating a condition of said thin film for exposure comprises a step of estimating line width uniformity of an etching of said thin film for inspection.

18. A method of inspecting a mask as set forth in claim 16, wherein
a step of performing inspection in said thin film for inspection comprises a step of measuring an in-plane uniformity of an etching in said thin film for inspection, and;
a step of estimating a condition of said thin film for exposure comprises a step of estimating an in-plane uniformity of an etching of said thin film for exposure.

19. A method of inspecting a mask as set forth in claim 16, wherein
a step of performing inspection in said thin film for inspection comprises a step of measuring a line width of said transmission portion in said multiple thin film for inspection formed separately each other, and;
a step of estimating a condition of said thin film for exposure comprises a step of estimating an in-plane uniformity of an etching of said thin film for exposure.

20. A method of inspecting a mask as set forth in claim 11, wherein
said transmission portion comprises an aperture formed in said thin film for exposure and thin film for inspection by a same etching step;
a step of performing inspection in said thin film for inspection comprises a step of obtaining a fluctuation of a line width and a corner rounding of when an aperture formed actually is compared with a design data of a thin film for inspection in said thin film for inspection that said transmission portion of which line width and/or interval are different is formed, and;
a step of estimating a condition of said thin film for exposure comprises a step of correcting a pattern of an aperture formed actually in said thin film for exposure by using a fluctuation of a line width and a corner rounding obtained in said thin film for inspection, and
a step of detecting a defect of a pattern of a thin film for exposure by referring a corrected data and a design data of a thin film for exposure.

21. A method of inspecting a mask as set forth in claim 20,
comprising a step of correcting a defect by irradiating a focused ion beam to a defect of a pattern detected in said thin film for exposure, and;
performing collimating of a focused ion beam by irradiating a focused ion beam to said thin film for inspection.

22. A method of inspecting a mask as set forth in claim 11, wherein
a step of performing inspection in said thin film for inspection comprises a step of confirming presence or absence of destruction of a pattern formed in said thin film for inspection in a narrower line width of a pattern formed in a portion that the probability of a pattern damage is the highest in said thin film for exposure, and;
in the case of confirming destruction of a pattern in said thin film for inspection, said thin film for exposure is estimated as a nonusable condition.

23. A method of inspecting a mask as set forth in claim 11, wherein
a step of performing inspection in said thin film for inspection comprises a step of confirming presence or absence of destruction of a pattern of a portion that said transmission portion is formed in said thin film for inspection in higher density of said transmission portion that the probability of a pattern damage is the highest in said thin film for exposure, and;
in the case of confirming destruction of a pattern in said thin film for inspection, said thin film for exposure is estimated as a nonusable condition.

24. A method of inspecting a mask as set forth in claim 11, wherein
a step of performing inspection in said thin film for inspection comprises a step of confirming presence or absence of change of a pattern after cleaning in said thin film for inspection in which said transmission portion of which line width and/or interval are different is formed, and;
a step of estimating a condition of said thin film for exposure comprises a step of estimating a pattern of said thin film for exposure after cleaning.

25. A method of inspecting a mask as set forth in claim 11, wherein
a step of performing inspection in said thin film for inspection comprises a step of confirming a foreign material remaining after cleaning in said thin film for inspection in which said transmission portion of which line width and/or interval are different is formed, and;
a step of estimating a condition of said thin film for exposure comprises a step of estimating a pattern of said thin film for exposure after cleaning.

26. A method of inspecting a mask as set forth in claim 11, wherein
a step of performing inspection in said thin film for inspection comprises a step of confirming a fluctuation of a line width of a pattern associated with deposition of contaminator by exposure in said thin film for inspection in which said transmission portion of which line width and/or interval are different is formed, and;
a step of estimating a condition of said thin film for exposure comprises a step of estimating a pattern of said thin film for exposure after using said thin film for exposure for exposure.

27. A method of producing semiconductor device performing a lithography process by using a thin film for exposure of a mask comprising:
a thin film for exposure having a transmission portion and a non-transmission portion of a beam for exposure in a predetermined pattern;
a thick film portion that is formed around said thin film for exposure and support said thin film for exposure, and;
a thin film for inspection that is formed at a distance from said thin film for exposure at a portion of said thick film and is having a transmission portion and a non-transmission portion of said beam for exposure.

28. A method of producing a semiconductor device as set forth in claim 27, wherein thickness and material of said thin film for inspection are equal to those of said thin film for exposure.
